# EUROPEAN PATENT SPECIFICATION

(11) **EP 2 034 169 B1**
(45) Date of publication and mention of the grant of the patent: **12.12.2012**
(21) Application number: 07017329.9
(22) Date of filing: 04.09.2007
(51) Int. Cl.: F02M 51/00, F02M 51/06

(54) **Electrical connector, actuator unit and injector**
Elektrischer Verbinder, Aktoreinheit und Injektor
Connecteur électrique, unité d'actionneur et injecteur

(43) Date of publication of application: 11.03.2009
(73) Proprietor: Continental Automotive GmbH, 30165 Hannover (DE)
(72) Inventor: D`onofrio, Mario, 19035 S.Stefano Magra (SP) (IT); Fischetti, Gianbattista, 19035 S.Stefano Magra (SP)56021 Cascina (PI) (IT)

(56) References cited:
- EP-A- 0 565 867
- EP-A- 1 724 880
- WO-A-2005/061881
- WO-A1-2007/012883
- FR-A- 2 772 996
- US-A- 5 209 204

## Description

The invention relates to an electrical connector for an injector, an actuator unit and an injector.

Injectors are in wide spread use, in particular for internal combustion engines where they may be arranged in order to dose the fluid into an intake manifold of the internal combustion engine or directly into the combustion chamber of a cylinder of the internal combustion engine.

In order to enhance the combustion process in view of the creation of unwanted emissions, the respective injector may be suited to dose fluids under very high pressures. The pressures may be in case of a gasoline engine, for example the range of up to 2 x 10⁷ N/m² (200 bar) or in the case of diesel engines in the range of more than 2 x 10⁸ N/m² (2,000 bar). The injection of fluids under such high pressures has to be carried out very precisely.

Injectors for an internal combustion engine comprise actuator units. In order to inject fuel, the actuator unit is energized so that a fluid flow through the fluid outlet portion of the injector is enabled.

US 5,209,204 A discloses a fuel distributor, including a plug connection which serves to provide electrical contact for the fuel injection valves comprising a socket and a plug. The plug connection that is located directly on the valve connection neck, in a region between two sealing elements that seal off a connection between the fuel distributor and the fuel injection valve, so that the fuel-carrying region is sealed off from the guide conduit, which in turn is sealed off from external influences such as splashing water. Thus, even the plug connections located in the region of the guide conduit are protected.

FR 2772996 A1 discloses a fuel injection electrical connector assembly with a locking ring. The locking ring has snap fit centre sections which snap into protrusions on the pluggable insert allowing rapid fitting of the plug into position.

The object of the invention is to create an electrical connector for an injector, an actuator unit and an injector, which are simply to be manufactured and which facilitate a reliable and precise function of the injector.

These objects are achieved by features of the independent claims. Advantageous embodiments of the invention are given in the sub-claims.

According to a first aspect the invention is distinguished by an electrical connector for an injector comprising a first connector element and a second connector element, the first connector element comprising an electric conductor being electrically coupable to a power supply, the second connector element comprising an electric pin being electrically coupable to an actuator unit of the injector, and the electric pin being electrically coupled to the electric conductor of the first connector element and being arranged and designed in a manner, that the electric pin is in a sliding contact with the electric conductor. The electrical connector comprises a spring element being arranged and designed to exert a force on the electric pin and/or the electric conductor to obtain a good sliding contact between the electric pin and the electric conductor. This has the advantage of a flexible solution with a sliding coupling and without rigid coupling. This solution allows a secure electric contact between the first connector element and the second connector element. This enables a secure electrical and mechanical coupling between the actuator unit and the first connector element. Consequently, there is no mechanical preload to the coupling area of the electric conductor of the first connector element with the electric pin of the second connector element. Furthermore, a damage of the injector can be avoided even in the case of high mechanical forces exerted on the actuator unit caused by electric energizing or temperature changes of the actuator unit. Furthermore, the spring element allows obtaining a reliable flexible contact between the electric pin and the electric conductor.

The invention is further distinguished by the electric conductor being arranged orthogonal to the longitudinal axis of the electric pin.

In a further advantageous embodiment of the invention one of the electric pin and the electric conductor comprises a rigid portion, and the other of the electric pin and the electric conductor comprises the spring element, and the spring element is in engagement with the rigid portion. This has the advantage of a secure and flexible electrical coupling between the electric pin and the electric conductor.

In a further advantageous embodiment of the invention the spring element is an elastic plug and the rigid portion comprises a ferrule with an opening, and the spring element is arranged in the opening of the ferrule. This allows a simple construction for the coupling of the electric pin and the electric conductor.

In a further advantageous embodiment of the invention the spring element is a spring clip, which comprises at least two arms. This has the advantage that a simple construction of the spring element is possible.

In a further advantageous embodiment of the invention the rigid portion comprises a tab, and the tab is arranged between the at least two arms of the spring element. This has the advantage of a simple construction for the coupling of the electric pin and the electric conductor.

In a further advantageous embodiment of the invention one of the electric pin and the electric conductor comprises a rigid portion, and the other of the electric pin and the electric conductor comprises the spring element and a plunger, and the spring element and the plunger are arranged and designed to press the plunger towards the rigid portion. This allows a simple construction for the coupling of the electric pin and the electric conductor.

In a further advantageous embodiment of the invention the plunger is of a material which comprises carbon. This has the advantage that carbon is a material by which the shape of the plunger can be adapted to obtain a good mechanical and electrical coupling between the electric pin and the electric conductor.

In a further advantageous embodiment of the invention the spring element is a coil spring. This has the advantage of a simple construction of the spring element.

In a further advantageous embodiment of the invention the spring element is a rubber spring. A rubber spring is simply to be manufactured and is a low cost solution for the spring element.

According to a second aspect the invention is distinguished by an actuator unit of an injector with an electrical connector and a piezo actuator.

In an advantageous embodiment of the second aspect of the invention the piezo actuator is mechanically coupled to the second connector element of the electrical connector and is designed as a cylinder with an axis extending in direction of the longitudinal axis of the electric pin of the second connector element. This has the advantage that the mechanical stress of the electric conductor and the electric pin due to vibrations of the piezo actuator can be kept small. Furthermore, the coupling between the electric conductor and the electric pin can be carried out in a robust manner.

According to a third aspect the invention is distinguished by an injector comprising the actuator unit of the second aspect of the invention, with the actuator unit being designed for acting on the valve assembly.

Exemplary embodiments of the invention are explained in the following with the help of schematic drawings. These are as follows:
- Figure 1: a first embodiment of an electrical connector in a side view, partially in a longitudinal section view,
- Figure 2: a further embodiment of the electrical connector in a side view, partially in a longitudinal section view,
- Figure 3: the electrical connector in a longitudinal section view along line III-III' of figure 1 and 2,
- Figure 4: a further embodiment of the electrical connector in a longitudinal section view,
- Figure 5: a further embodiment of the electrical connector in a longitudinal section view,
- Figure 6a: the electrical connector in a side view along line VI A-VI A' of figures 4 and 5,
- Figure 6b: a further embodiment of the electrical connector in a side view,
- Figure 7,: a further embodiment of the electrical connector in a side view, partially in a longitudinal section view,
- Figure 8,: a further embodiment of the electrical connector in a side view, partially in a longitudinal section view,
- Figure 9: the electrical connector in a side view along line IX-IX' of figures 7 and 8, and
- Figure 10,: an injector in a longitudinal section view.

Elements of the same design and function that appear in different illustrations are identified by the same reference characters.

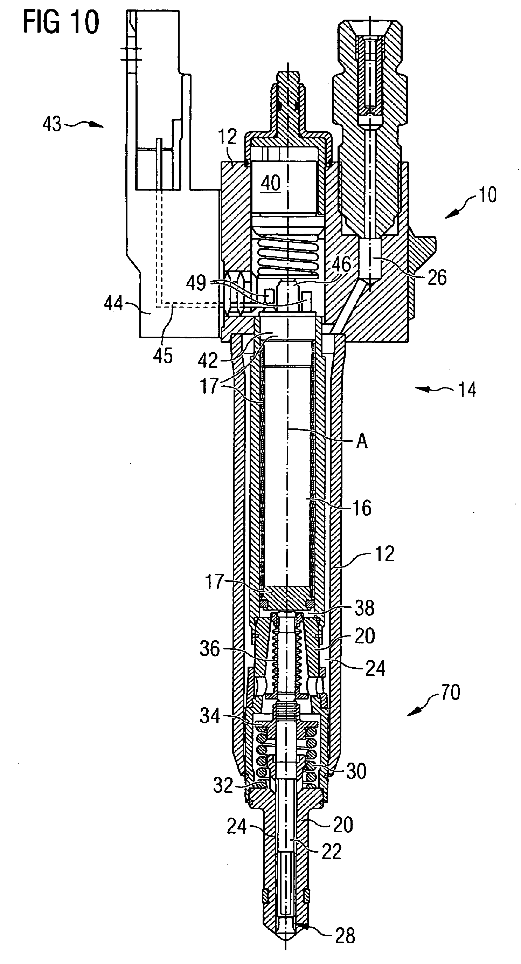

Figure 10 shows an injector 10 which is used as a fuel injector for an internal combustion engine and comprises an actuator unit 14 and a valve assembly 70.

The injector 10 has a housing 12 with a tubular shape and a central longitudinal axis A and a cavity 24 which is axially led through the housing 12. The actuator unit 14 is inserted into the cavity 24 of the housing 12 and comprises a piezo actuator 16, which changes its axial length depending on a control signal applied to it. A piezo actuator housing 17 encloses the piezo actuator 16 so that the piezo actuator 16 is stored in a mechanical robust manner.

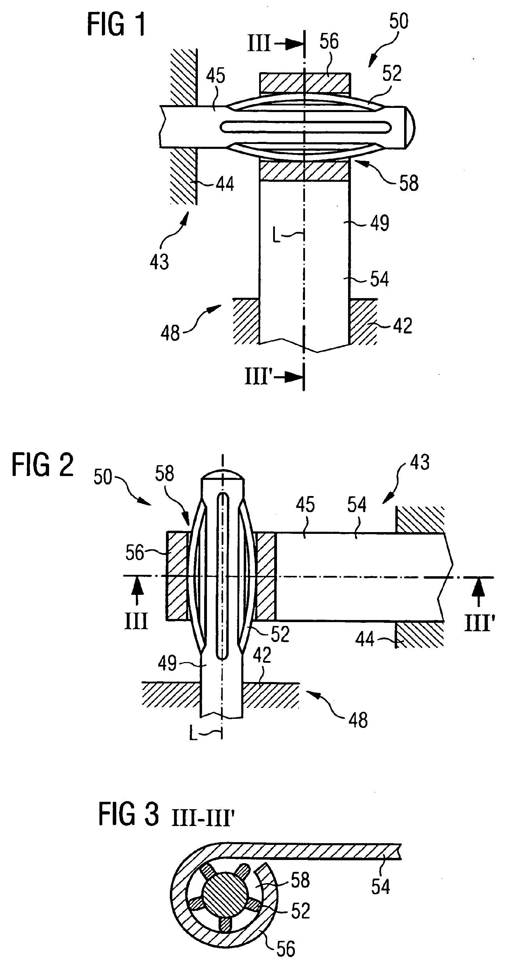

The injector 10 has an electrical connector 50 (figures 1-9) which is electrically and mechanically coupled to the piezo actuator 16 to supply the piezo actuator 16 with electric energy.

The valve assembly 70 comprises a valve body 20 and a part of the cavity 24 which is axially led through the valve body 20. The cavity 24 of the housing 12 comprises a fluid inlet portion 26. The fluid inlet portion 26 is designed to be connected to a high pressure fuel chamber of an internal combustion engine, the fuel is stored under high pressure, for example, under the pressure of above 200 bar. On one of the free ends of the cavity 24, a fluid outlet portion 28 is formed which is closed or open depending on the axial position of a valve needle 22.

The valve body 20 has a valve body spring rest 32 and the valve needle 22 comprises a valve needle spring rest 34, both spring rests 32, 34 supporting a main spring 30 arranged between the valve body 20 and the valve needle 22.

The injector 10 is of an outward opening type. In an alternative embodiment of the injector 10 it may be of an inward opening type. Between the valve needle 22 and the valve body 20 a bellow 36 is arranged which is sealingly coupling the valve body 20 with the valve needle 22. By this a fluid flow between the cavity 24 and a chamber 38 is prevented. Furthermore, the bellow 36 is formed and arranged in a way that the valve needle 22 is actuable by the actuator unit 14.

The piezo actuator housing 17 enclosing the piezo actuator 16 comprises a top cap 42. The top cap 42 of the piezo actuator housing 17 is arranged at an end of the piezo actuator 16 facing away from the valve assembly 70. The actuator unit 14 further comprises a piston 46. A thermal compensator unit 40 is arranged in the cavity 24 of the housing 12 and is mechanically coupled to the piston 46 of the piezo actuator 16. The thermal compensation unit 40 enables to set an axial preload force on the actuator unit 14 via the piston 46 to compensate changes of the fluid flow through the fluid outlet portion 28 in the case of temperature changes of the injector 10.

The piezo actuator 16 further comprises electric pins 49 to supply the piezo actuator 16 with electric energy. The piezo actuator 16 changes its length in axial direction depending on electric energy supplied to it. By changing its length the piezo actuator 16 can exert a force to the valve needle 22. The force from the piezo actuator 16 being exerted to the valve needle 22 in an axial direction allows or prevents a fluid flow through the fluid outlet portion 28.

Figures 1 to 9 show detailed views of the electrical connector 50.

The electrical connector 50 of the injector 10 comprises a first connector element 43 with a non-conductive connector body 44 in which an electric conductor 45 is arranged. Electric energy can be supplied to the electric conductor 45 of the first connector element 43 by a not shown power supply.

The electrical connector 50 of the injector 10 has further a second connector element 48 comprising the electric pins 49. The electric conductor 45 of the first connector element 43 is electrically coupled to one of the electric pins 49 of the second connector element 48 which is electrically coupled to the piezo actuator 16. Consequently, electric energy can be supplied to the piezo actuator 16 via the first connector element 43 and the second connector element 48 in a simple manner.

Figure 1 shows the electrical connector 50 with the first connector element 43 and the second connector element 48. The electric conductor 45 of the first connector element 43 comprises a spring element 52. In this embodiment the spring element 52 is formed as a banana plug. The second connector element 48 comprises the electric pin 49. The electric pin 49 has a longitudinal axis L and a rigid portion 54. The rigid portion has a ferrule 56 with an opening 58. The opening 58 is cylindrical and the spring element 52 is arranged in the opening 58 of the ferrule 56.

The rigid portion 54 is extending in the direction of the longitudinal axis L which is parallel to the axis A of the extension of the piezo actuator 16.

Therefore, a movement of the piezo actuator 16 in axial direction allows a flexible movement between the rigid portion 54 and the spring element 52. Consequently, in the case of an axial movement of the piezo actuator 16 in direction of the longitudinal axis L a secure electrical coupling between the first connector element 43 and the second connector element 48 can be obtained.

Figure 3 shows the electrical connector 50 in a longitudinal section view along line III-III' of figure 1, with the spring element 52 being arranged in the opening 58 of the cylindrical ferrule 56.

The embodiment of the electrical connector 50 shown in figure 2 differs from the embodiment of figure 1 by that the first connector element 43 comprises the rigid portion 54 with the ferrule 56 and the opening 58, and the second connector element 48 comprises the spring element 52 which is in engagement with the ferrule 56 of the first connector element 43. In this embodiment, an axial movement of the piezo actuator 16 causes an axial movement of the spring element 52 in the opening 58 of the ferrule 56 in direction of the longitudinal axis L. In the case of an axial movement of the piezo actuator 16 a good electrical connection between the first connector element 43 and the second connector element 48 is possible.

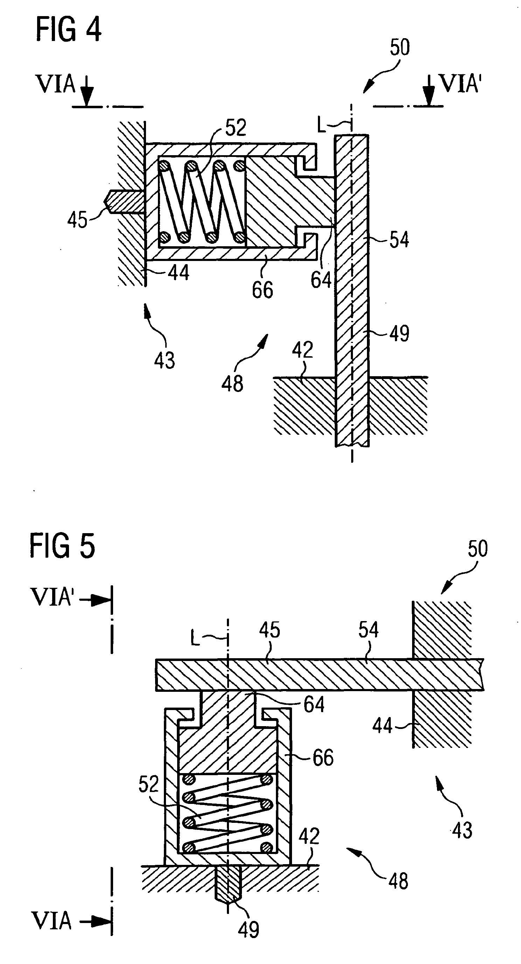

In a further embodiment of the electrical connector 50 shown in figure 4 the first connector element 43 comprises the spring element 52 and a plunger 64 which are arranged in a housing 66. The plunger 64 and the housing 66 are of materials which are electrically conductive and which allow an electric coupling between the electrical conductor 45 and the electric pin 49 with the rigid portion 54 of the second connector element 48. This arrangement allows a good electrical and mechanical contact between the plunger 64 and the rigid portion 54.

In the case of an axial and/or radial movement of the piezo actuator 16 relative to the longitudinal axis L of the electric pin 49 the spring element 52 forces the plunger 64 to remain in close contact with the rigid portion 54. In a preferred embodiment of the electrical connector 50 the plunger 64 is of a material which comprises carbon. In particular, the plunger 64 consists of carbon. By this, the abrasive character of carbon enables a good adaptation of the shape of the plunger 64 to the shape of the electric pin 49. Consequently, a good contact between the plunger 64 and the rigid portion 54 is possible.

In the embodiment of the electrical connector 50 shown in figure 4 the spring element 52 is a coil spring. In a further embodiment the spring element 52 is a rubber spring. If the spring element 52 is a rubber spring it can be simply manufactured and it is possible to obtain a low cost solution for the electrical connector 50.

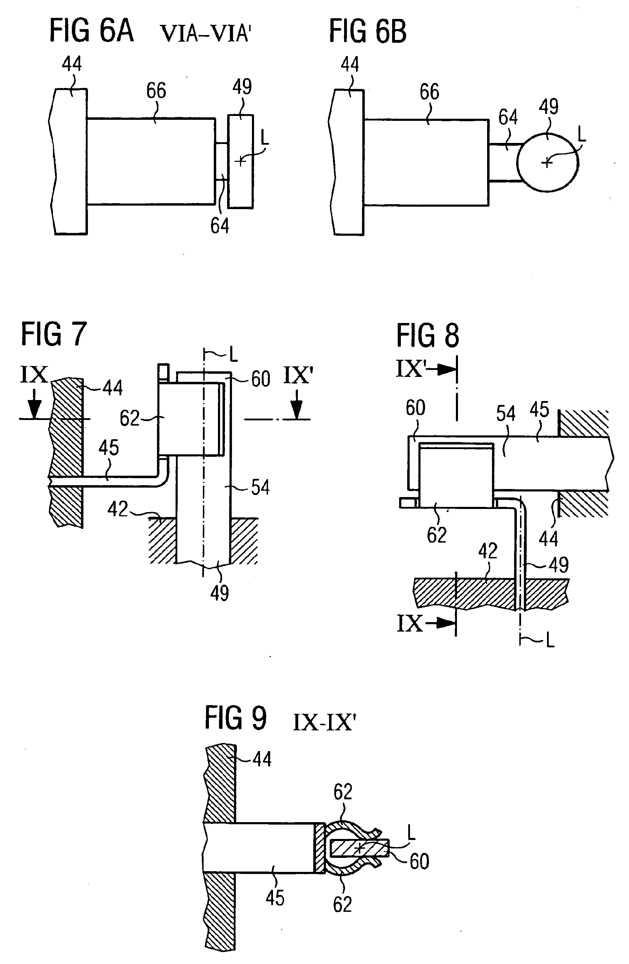

It is furthermore preferred, that the electric pin 49 has a rectangular cross-section, and the plunger 64 has a planar outer wall which is in contact with the electric pin 49. Consequently, a good contact between the plunger 64 and the electric pin 49 can be enabled (figure 6a).

In a further embodiment, the electric pin 49 has a circular cross-section, and the plunger 64 comprises a recess being shaped as a segment of a circle. This allows a very close contact between the plunger 64 and the electric pin 49 (figure 6b).

In a further embodiment of the electric connector 50 as shown in figure 5 the second connector element 48 of the piezo actuator 16 comprises the spring element 52, the plunger 64 and the housing 66 of the spring element 52 and the plunger 64. The first connector element 43 comprises the rigid portion 54. In this embodiment, an axial movement of the piezo actuator 16 relative to the longitudinal axis L is absorbed by the spring element 52 and a good electrical contact between the first connector element 43 and the second connector element 48 can be obtained.

Figure 7 shows a further embodiment of the electrical connector 50 wherein the first connector element comprises the spring element 52. The spring element 52 is formed as a spring clip which comprises two arms 62. A tab 60 being part of the rigid portion 54 of the second connector element 48 is arranged between the two arms 62 of the spring element 52.

In the case of an axial movement of the piezo actuator 16 relative to the longitudinal axis L a good sliding contact between the tab 60 and the arms 62 is obtained, which enables a good electrical contact between the first connector element 43 and the second connector element 48.

A further embodiment of the electrical connector 50 is shown in figure 8. The electric pin 49 comprises the arms 62 and the rigid portion 54 of the electric conductor 45 comprises the tab 60. Similar to the embodiment of figure 7 the tab 60 and the arms 62 are in a sliding contact and in the case of a relative movement between the first connector element 43 and the second connector element 48 a good electrical contact between the electric conductor 45 and the electric pin 49 can be obtained.

In the following, the function of the injector 10 will be described:
The fluid is led from the fluid inlet portion 26 through the housing 12 to the fluid outlet portion 28.

The valve needle 22 prevents a fluid flow through the fluid outlet portion 28 in the valve body 20 in a closing position of the valve needle 22. Outside of the closing position of the valve needle 22, the valve needle 22 enables the fluid flow through the fluid outlet portion 28.

The piezo actuator 16 may change its axial length if it is energized. By changing its length the piezo actuator 16 may exert a force on the valve needle 22. The valve needle 22 is able to move in axial direction out of the closing position. Outside the closing position of the valve needle 22 there is a gap between the valve body 20 and the valve needle 22 at an axial end of the injector 10 facing away from the piezo actuator 16. The main spring 30 can force the valve needle 22 via the valve needle spring rest 34 towards the piezo actuator 16. In the case the piezo actuator 17 is de-energized the piezo actuator 16 shortens its length. The main spring 30 can force the valve needle 22 to move in axial direction in its closing position. It is depending on the force balance between the force on the valve needle 22 caused by the piezo actuator 16 and the force on the valve needle 22 caused by the main spring 30 whether the valve needle 22 is in its closing position or not.

If the piezo actuator 16 of the injector 10 is energized through the electrical connector 50 the valve needle 22 is enabled to move as described above and to exert a reaction force on the piezo actuator 16. Due to this a movement of the piezo actuator 16 relative to the electrical connector 50 can occur in a manner that forces are exerted on the first connector element 43 and the second connector element 48.

The piezo actuator 16 is supplied with electrical energy in a secure manner as the first connector element 43 and the second connector element 48 are in sliding contact relative to each other. On the other hand, the sliding contact can prevent the transmission of mechanical stress between the first connector element 43 and the second connector element 48 due to movements of the piezo actuator 16 caused by electric energizing or temperature changes.

The sliding contact results in a robust electrical coupling between the connector elements 43, 48 of the electrical connector 50, and, in particular, between the electric conductor 45 and the electric pin 49. This allows obtaining a long life time of the electrical connector 50 and the piezo actuator 16.

## Claims

1. Electrical connector (50) for an injector (10) comprising a first connector element (43) and a second connector element (48),
the first connector element (43) comprising an electric conductor (45) being electrically coupable to a power supply, the second connector element (48) comprising an electric pin (49),
the electric pin (49) being electrically coupable to an actuator unit (14) of the injector (10), comprising a longitudinal axis (L), being electrically coupled to the electric conductor (45) of the first connector element (43) and being arranged and designed in a manner, that the electric pin (49) is in a sliding contact with the electric conductor (45),
**characterized in that**
the electric conductor (45) is arranged orthogonal to the longitudinal axis (L) of the electric pin (49), and **in that** the electrical connector (50) comprises a spring element (52) being arranged and designed to exert a force on the electric pin (49) and/or the electric conductor (45) to obtain a good sliding contact between the electric pin (49) and the electric conductor (45).

2. Electrical connector (50) according to claim 1, wherein one of the electric pin (49) and the electric conductor (45) comprises a rigid portion (54), and the other of the electric pin (49) and the electric conductor (45) comprises the spring element (52), and the spring element (52) is in engagement with the rigid portion (54).

3. Electrical connector (50) according to one of the preceding claims, wherein the spring element (52) is an elastic plug and the rigid portion (54) comprises a ferrule (56) with an opening (58), and the spring element (52) is arranged in the opening (58) of the ferrule (56).

4. Electrical connector (50) according to one of the claims 1 to 2, wherein the spring element (52) is a spring clip, which comprises at least two arms (62).

5. Electrical connector (50) according to claim 4, wherein the rigid portion (54) comprises a tab (60), and the tab (60) is arranged between the at least two arms (62) of the spring element (52).

6. Electrical connector (50) according to claim 1, wherein one of the electric pin (49) and the electric conductor (45) comprises a rigid portion (54), and the other of the electric pin (49) and the electric conductor (45) comprises the spring element (52) and a plunger (64), and the spring element (52) and the plunger (64) are arranged and designed to press the plunger (64) towards the rigid portion (54).

7. Electrical connector (50) according to claim 6, wherein the plunger (64) is of a material which comprises carbon.

8. Electrical connector (50) according to claim 6 or 7, wherein the spring element (52) is a coil spring.

9. Electrical connector (50) according to claim 6 or 7, wherein the spring element (52) is a rubber spring.

10. Actuator unit (14) for an injector (10), with an electrical connector (50) according to one of the preceding claims and a piezo actuator (16).

11. Actuator unit (14) according to claim 10, wherein
the piezo actuator (16) is mechanically coupled to the second connector element (48) of the electrical connector (50) and is designed as a cylinder with an axis extending in direction of the longitudinal axis (L) of the electric pin (49) of the second connector element (48).

12. Injector (10) with a valve assembly (70) and an actuator unit (14) according to claim 10 or 11, with the actuator unit (14) being designed for acting on the valve assembly (70).

## Patentansprüche

1. Elektrischer Stecker (50) für eine Einspritzdüse (10),
der ein erstes Verbindungselement (43) und ein zweites Verbindungselement (48) umfasst, wobei
das erste Verbindungselement (43) einen elektrischen Leiter (45) umfasst, der elektrisch verbindbar mit einer Energieversorgung ist,
das zweite Verbindungselement (48) einen elektrischen Stift (49) umfasst, wobei der elektrische Stift (49) elektrisch verbindbar mit einer Stellantriebeinheit (14) der Einspritzdüse (10) ist, die eine longitudinale Achse (L) aufweist, die mit dem elektrischen Leiter des ersten Verbindun
gselements (43) elektrisch verbunden ist und angeordnet und in einer Weise ausgebildet ist, dass der elektrische Stift (49) in einem Gleitkontakt mit dem elektrischen Leiter (45) ist, **dadurch gekennzeichnet, dass** der elektrische Leiter (45) senkrecht zu der longitudinalen Achse (L) des elektrischen Stifts (49) angeordnet ist, und dass der elektrische Stecker (50) ein Federelement (52) umfasst, das angeordnet und dazu ausgebildet ist, eine Kraft auf den elektrischen Stift (49) auszuüben, und/oder den elektrischen Leiter (45) umfasst, um einen guten Gleitkontakt zwischen dem elektrischen Stift (49) und dem elektrischen Leiter (45) zu erhalten.

2. Elektrischer Stecker (50) nach Anspruch 1, wobei einer der elektrischen Stifte (49) und der elektrische Leiter (45) einen starren Teil (54) umfassen, und der andere elektrische Stift (49) und der elektrische Leiter (45) das Federelement (52) umfassen und das Federelement (52) im Eingriff mit dem starren Teil (54) ist.

3. Elektrischer Stecker (50) nach einem der vorhergehenden Ansprüche, wobei das Federelement (52) ein elastischer Stecker ist und der starre Teil (54) eine Pressklemme (56) mit einer Öffnung (58) umfasst und das Federelement (52) in der Öffnung (58) der Pressklemme (56) angeordnet ist.

4. Elektrischer Stecker (50) nach einem der Ansprüche 1 bis 2, wobei das Federelement (52) eine Federklemme ist, die mindestens zwei Arme (62) umfasst.

5. Elektrischer Stecker (50) nach Anspruch 4, wobei der starre Teil (54) einen Streifen (60) umfasst und der Streifen (60) zwischen den mindestens zwei Armen (62) des Federelements (52) angeordnet ist.

6. Elektrischer Stecker (50) nach Anspruch 1, wobei einer der elektrischen Stifte (49) und der elektrische Leiter (45) einen starren Teil (54) umfassen und der andere elektrische Stift (49) und der elektrische Leiter (45) das Federelement (52) und einen Kolben (64) umfassen und das Federelement (52) und der Kolben angeordnet und dazu ausgebildet sind, den Kolben (64) gegen den starren Teil (54) zu drücken.

7. Elektrischer Stecker (50) nach Anspruch 6, wobei der Kolben (64) aus einem Material ist, das Kohlenstoff umfasst.

8. Elektrischer Stecker (50) nach Anspruch 6 oder 7, wobei das Federelement (52) eine Schraubenfeder ist.

9. Elektrischer Stecker (50) nach Anspruch 6 oder 7, wobei das Federelement (52) eine Gummifeder ist.

10. Stellantriebseinheit (14) für eine Einspritzdüse (10) mit einem elektrischen Stecker (50) nach einem der vorhergehenden Ansprüchen und einem Piezo-Aktuator (16).

11. Stellantriebseinheit (14) nach Anspruch 10, wobei der Piezo-Aktuator (16) mechanisch mit einem zweiten Verbindungselement (48) des elektrischen Steckers (50) verbunden ist und als ein Zylinder mit einer sich in Richtung der longitudinalen Achse (L) des elektrischen Stifts (49) des zweiten Verbindungselements (48) erstreckenden Achse ausgebildet ist.

12. Einspritzdüse (10) mit einem Ventilaufbau (70) und einer Stellantriebseinheit (14) nach Anspruch 10 oder 11, wobei die Stellantriebseinheit (14) dazu ausgebildet ist, auf den Ventilaufbau (70) einzuwirken.

## Revendications

1. Connecteur électrique (50) destiné à un injecteur (10) qui comprend un premier élément de connexion (43) et un second élément de connexion (48),
le premier élément de connexion (43) comprenant un conducteur électrique (45) pouvant être électriquement relié à une alimentation, le second élément de connexion (48) comprenant une broche électrique (49),
la broche électrique (49) pouvant être électriquement reliée à une unité d'actionneur (14) de l'injecteur (10), comprenant un axe longitudinal (L), électriquement reliée au conducteur électrique (45) du premier élément de connexion (43), et disposée et conçue de sorte que la broche électrique (49) soit en contact coulissant avec le conducteur électrique (45), **caractérisé en ce que**
le conducteur électrique (45) est disposé orthogonalement par rapport à l'axe longitudinal (L) de la broche électrique (49), et **en ce que** le connecteur électrique (50) comprend un élément de ressort (52) disposé et conçu pour exercer une force sur la broche électrique (49) et/ou le conducteur électrique (45) afin d'obtenir un bon contact coulissant entre la broche électrique (49) et le conducteur électrique (45).

2. Connecteur électrique (50) selon la revendication 1, dans lequel l'un de la broche électrique (49) et du conducteur électrique (45) comprend une partie rigide (54), et l'autre de la broche électrique (49) et du conducteur électrique (45) comprend l'élément de ressort (52), et l'élément de ressort (52) est engagé avec la partie rigide (54).

3. Connecteur électrique (50) selon l'une des revendications précédentes, dans lequel l'élément de ressort (52) est une fiche élastique et la partie rigide (54) comprend une férule (56) munie d'une ouverture (58), et l'élément de ressort (52) est disposé dans l'ouverture (58) de la férule (56).

4. Connecteur électrique (50) selon l'une des revendications 1 ou 2, dans lequel l'élément de ressort (52) est une attache à ressort qui comprend au moins deux bras (62).

5. Connecteur électrique (50) selon la revendication 4, dans lequel la partie rigide (54) comprend une languette (60), et la languette (60) est disposée entre les au moins deux bras (62) de l'élément de ressort (52).

6. Connecteur électrique (50) selon la revendication 1, dans lequel l'un de la broche électrique (49) et du conducteur électrique (45) comprend une partie rigide (54), et l'autre de la broche électrique (49) et du conducteur électrique (45) comprend l'élément de ressort (52) et un plongeur (64), et l'élément de ressort (52) et le plongeur (64) sont disposés et conçus pour pousser le plongeur (64) vers la partie rigide (54).

7. Connecteur électrique (50) selon la revendication 6, dans lequel le plongeur (64) est réalisé dans un matériau qui comprend du carbone.

8. Connecteur électrique (50) selon la revendication 6 ou 7, dans lequel l'élément de ressort (52) est un ressort hélicoïdal.

9. Connecteur électrique (50) selon la revendication 6 ou 7, dans lequel l'élément de ressort (52) est un ressort en caoutchouc.

10. Unité d'actionneur (14) destinée à un injecteur (10), avec un connecteur électrique (50) selon l'une des revendications précédentes et un actionneur piézoélectrique (16).

11. Unité d'actionneur (14) selon la revendication 10, dans laquelle l'actionneur piézoélectrique (16) est mécaniquement couplé au second élément de connexion (48) du connecteur électrique (50) et est conçu comme un cylindre ayant un axe qui s'étend dans la direction de l'axe longitudinal (L) de la broche électrique (49) du second élément de connexion (48).

12. Injecteur (10) avec ensemble de soupape (70) et unité d'actionneur (14) selon la revendication 10 ou 11, l'unité d'actionneur (14) étant conçue pour agir sur l'ensemble de soupape (70).
